# EUROPEAN PATENT APPLICATION

(11) **EP 0 887 932 A1**
(43) Date of publication of application: **30.12.1998**
(21) Application number: 97830297.4
(22) Date of filing: 24.06.1997
(51) Int. Cl.: H03K 17/06

(54) **Control of the body voltage of a high voltage LDMOS**

(71) Applicant: STMicroelectronics S.r.l., 20041 Agrate Brianza MI (IT)
(72) Inventor: Genova, Angelo, 93010 Delia (IT); Tarantola, Mario, 20010 Bareggio (IT); Cantone, Giuseppe, 96100 Siracusa (IT); Gariboldi, Roberto, 20084 Lacchiarella (IT)
(74) Representative: Pellegri, Alberto

(57) **Abstract**

A circuit for charging a capacitance (C) by mens of an LDMOS (LD) integrated transistor controlled in a manner to emulate a high voltage charging diode of the capacitance and comprising a circuital device to avert the switch-on parasitic PNP transistors of the LDMOS structure during transient states, composed of a number n of junctions (d1, D2, .. , Dn) directly biased between a source node (S) and a body node (VB) of the LDMOS transistor, at least a current generator (I), referred to the potential of a ground node of the circuit, at least a switch (SW1) between said source node (S) and the first junction (D1) of said chain of directly biased junctions and a limiting resistance (R1) connected between said body node and said current generator (I) referred to ground in which the (SW1) switch is open during a charging phase of the capacitance (C) and is closed when the charging voltage of the capacitance goes over a preestablished threshold by a control signal, further comprises
switching means (Sd1, Sd2, Sd3, Sd4) controlled by a logic signal (UVLO), active during the phase in which the supply voltage (Vs) of the integrated circuit is lower than the minimum switch-on voltage of the same integrated circuit, for charging said body node (VB) with a current whose maximum value is limited to a preestablished value.

## Description

The present invention relates to integrated circuits and in particular to driving circuits of power stages. In particular the invention refers to a bootstrap or similar system wherein a capacitor is charged by means of an LDMOS integrated transistor emulating a high voltage diode.

In integrated circuits that comprise output stages destined to drive discrete power devices or themselves integrated on the same chip containing the control circuitry, it is recurrent the use of a bootstrap capacitor to ensure a correct powering of the driving stage. In these systems, it is essential that the bootstrap capacitance is charged in very short periods of time and this is usually attained through a diode emulator LDMOS transistor used to rapidly charge the bootstrap capacitance.

In the case of a driving circuit for a so-called High Side Driver (HSD) of a half-bridge output stage, the LDMOS should be capable of charging the bootstrap capacitance when the HSD is referred to low voltage (that is when its output is low), while the LDMOS should emulate a high impedance when the HSD is referred to high voltage (that is, when its output is high). These functioning conditions must be also ensured during the HSD switching phase from high to low voltage or vice versa, despite of the possible current injections of deriving from charging and discharging processes of the capacitances associated to the LDMOS integrated structure that must sustain the high voltage supply of the power device.

The publication WO 94/27370 discloses a half-bridge circuit comprising a driving module of the lower device and a driving floating module of the higher power device, in which the driving module of the higher transistor is realized in an isolated well region and a properly controlled LDMOS transistor emulates a high voltage charging diode of a bootstrap capacitor.

In these cases it is necessary to control the effects of the parasite bipolar junction transistors associated to an LDMOS integrated structure.

The document EP-A-0743752, points out and describes certain conditions that originate problems tied to the switch-on of parasite transistors of the LDMOS integrated structure, describing also different circuit layouts capable to avert current consumptions caused by the switch-on of parasite transistors of the LDMOS integrated structure and to avoid the occurrence of conditions that may cause the destruction of the integrated device itself.

The above cited European patent application EP-A-0743752, is herein incorporated by way of direct reference. Figure 1 highlights the protecting circuit device described in said previous European patent application.

According to the solution described in said previous European patent application, there exists a functioning phase of the integrated circuit, referred to as UVLO, when the voltage supply Vs is less than the minimum switch-on voltage of the entire integrated device including also the LDMOS, during which, being SW1 and SW2 both open, the potential of the VB body node of the LDMOS structure is kept at the circuit ground potential.

On the other hand these so-called multipurpose integrated devices may be useful in many applications, during a UVLO phase, for charging the bootstrap capacitance (C). In this a case, if the LDMOS body structure is connected to ground, its efficiency in charging the bootstrap capacitance is considerably diminished (in fact, in this case the gate-drain (Vgd) voltage must be of many Volts to keep in a conducting state the LDMOS integrated transistor and to contrast the notable body effect that would increase its threshold voltage (Vth).

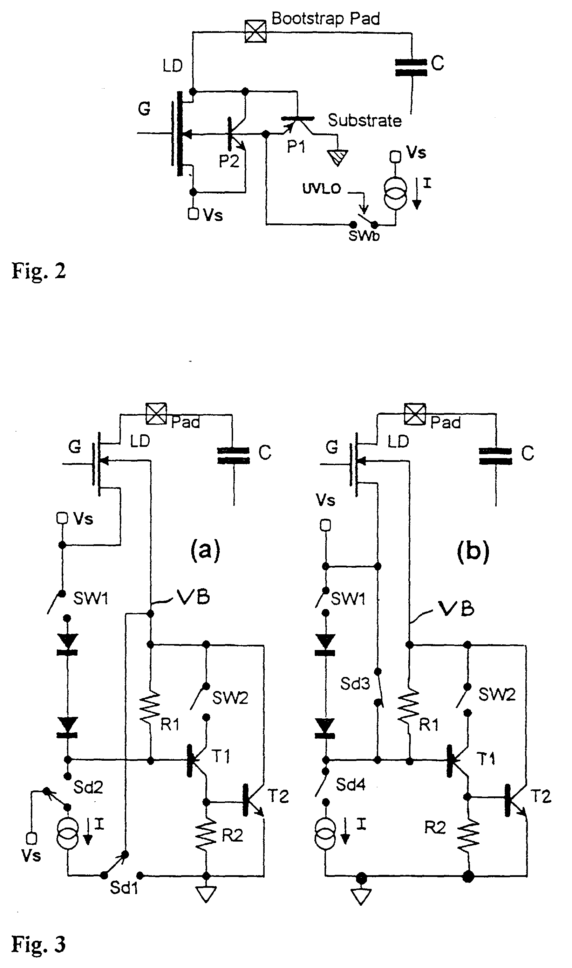

In addition, by keeping during this functioning phase, the body of the LDMOS structure to ground, when the threshold voltage of the UVLO control signal has a particularly high value (often greater than 10V in the case of fabrication processes referred to as BCD off-line) there exists the risk of a breakdown of the base-emitter junction of the parasitic bipolar transistor (P2 in the scheme of figure 2).

The purpose of the present invention is that of providing means to prevent the above cited problems under any functioning condition of the integrated circuit.

This objective is fully achieved by the present invention through a circuital device capable of connecting, during a UVLO phase, the LDMOS body node potential at the voltage existing on the bootstrap capacitance plus a Vbe of a parasitic junction bipolar transistor of the same LDMOS integrated structure. In this manner, the body effect on the threshold voltage of the LDMOS transistor is effectively limited, without notably aggravating the consumption of current across the parasitic transistors, allowing for a more efficient charge of the capacitance.

The limit for the charging current of the body node may be assured, according to a first embodiment of the invention, by charging the same body node by means of the same current generator already used by the control circuit of the parasitic transistors according to said preceding European patent application N. 95830207.7.

Alternatively, a certain limit for the charging current of the body node may be assured through a resistance in series to the charging current path, which is switched, during the UVLO phase, on the Vs supply node.

The various aspects, features and advantages of the present invention will become apparent upon perusal of the following detailed description when taken in conjunction with the attached drawings, wherein:

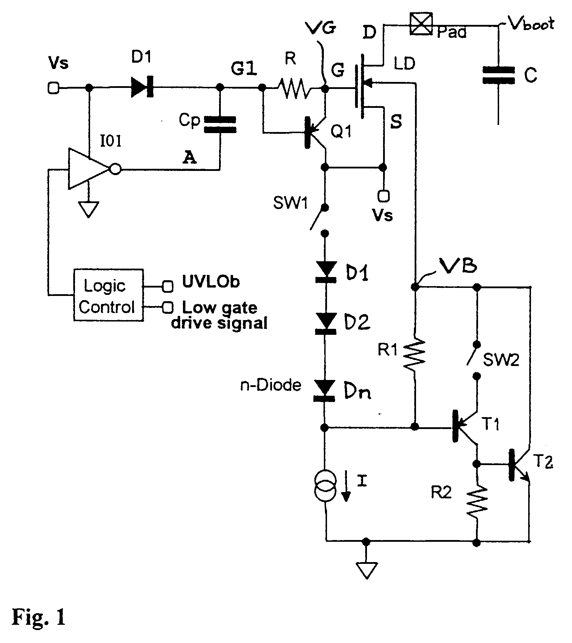

**Figure 1** shows, as previously cited, the control scheme of the LDMOS parasitic transistors, according to the known technique;
**Figure 2** schematically shows the parasitic bipolar transistors of the LDMOS structure and the general protecting principle of the present invention;
**Figure 3a and 3b** show two alternative embodiments of the invention.

The general scheme of the device of the invention is illustrated in figure 2.

Essentially, the device comprises at least an SWb switch which is closed by the UVLO signal during a functioning phase in which the Vs voltage supply of the circuit is lower than the switch-on threshold voltage of the LD (LDMOS) integrated transistor. The closing of the SWb switch determines the body node charge of the LD integrated transistor whose potential is increased by a Vbe if compared to the bootstrap voltage.

An essential aspect of the invention consists in that the charging of the VB body node is undertaken by limiting the maximum value of the I charging current so that the current that flows toward the substrate due to the switch-on of the LDMOSD P1 and P2 parasitic bipolar transistors is limited.

Figure 3a shows a first embodiment of the circuital device of the invention according to which, through the Sd1 and Sd2 switches, both controlled by the UVLO signal (not indicated in figure) the I current generator is connected respectively to the VB body node of the LDMOS transistor and to the Vs. supply node.

The I current generator, already existing in the switch-on control circuit of the parasitic transistors, limits the maximum charging current of the Vb node, without substantially incrementing the consumption of the LDMOS control system.

According to an alternative embodiment of the invention, shown in figure 3b, the charging of the VB body node takes place by commanding during an UVLO phase the two Sd3 and Sd4 switches as illustrated, connecting then through Sd3 and the limiting resistance R1, the VB node to the Vs supply node.

The Sd4 switch has the function of disconnecting, during this UVLO phase, the I current generator of the LDMOS control circuit, eliminating thus the absorption of current.

## Claims

1. Circuit for charging a capacitance (C) by mens of an LDMOS (LD) integrated transistor controlled in a manner to emulate a high voltage charging diode of the capacitance and comprising a circuital device to avert the switch-on of parasitic PNP transistors of the LDMOS structure during transient states, composed of a number n of junctions (d1, D2, .. , Dn) directly biased between a source node (S) and a body node (VB) of the LDMOS transistor, at least a current generator (I), referred to the potential of a ground node of the circuit, at least a switch (SW1) between said source node (S) and the first junction (D1) of said chain of directly biased junctions and a limiting resistance (R1) connected between said body node and said current generator (I) referred to ground in which the (SW1) switch is open during a charging phase of the capacitance (C) and is closed when the charging voltage of the capacitance goes over a preestablished threshold by a control signal, characterized in that it further comprises
switching means (Sd1, Sd2, Sd3, Sd4) controlled by a logic signal (UVLO), active during the phase in which the supply voltage (Vs) of the integrated circuit is lower than the minimum switch-on voltage of the same integrated circuit, for charging said body node (VB) with a current whose maximum value is limited to a preestablished value.

2. The circuit of claim 1, characterized in that said body node (VB) is charged with a current limited by said current generator (I) operatively switched by said switching means (Sd1, Sd2) between a supply node (Vs) of the circuit and said body node (VB).

3. The circuit according to claim 1, characterized in that said body node (VB) is charged through said resistance (R1) coupled by said switching means (Sd3) to a supply node (Vs.)

4. The circuit according to claim 3, characterized in that said second switching means (Sd4) isolate said current generator (I) during said charging phase of the body node (VB).
